Europäisches Patentamt

European Patent Office

Office européen des brevets

(19)

(11) **EP 0 438 537 B1**

(12) **EUROPÄISCHE PATENTSCHRIFT**

(45) Veröffentlichungstag und Bekanntmachung des
Hinweises auf die Patenterteilung:
**11.12.1996 Patentblatt 1996/50**

(21) Anmeldenummer: **90902602.3**

(22) Anmeldetag: **09.02.1990**

(51) Int Cl.⁶: **G01R 31/36**

(86) Internationale Anmeldenummer:
**PCT/CH90/00029**

(87) Internationale Veröffentlichungsnummer:
**WO 90/09598 (23.08.1990 Gazette 1990/20)**

(54) **VORRICHTUNG ZUR ÜBERWACHUNG UND ANZEIGE EINER BESTIMMTEN MINDEST-ENERGIERESERVE VON BATTERIEN**

A DEVICE FOR MONITORING AND INDICATING A GIVEN MINIMUM BATTERY POWER RESERVE

DISPOSITIF DE CONTROLE ET D'INDICATION D'UNE RESERVE D'ENERGIE MINIMUM DETERMINEE DANS LES BATTERIES

(84) Benannte Vertragsstaaten:
**DE FR GB IT SE**

(30) Priorität: **11.02.1989 CH 467/89**

(43) Veröffentlichungstag der Anmeldung:
**31.07.1991 Patentblatt 1991/31**

(73) Patentinhaber: **D-H Elektronik GmbH**
**71665 Vaihingen (DE)**

(72) Erfinder: **Nagy, Sandor**
**8057 Zürich (CH)**

(74) Vertreter: **Patentanwälte**
**Schaad, Balass, Menzl & Partner AG**
**Dufourstrasse 101**
**Postfach**
**8034 Zürich (CH)**

(56) Entgegenhaltungen:
EP-A- 0 207 054          GB-A- 1 473 633
GB-A- 1 575 407          US-A- 4 558 281

**Beschreibung**

Die Erfindung bezieht sich auf eine Vorrichtung der im Oberbegriff des Anspruchs 1 genannten Art.

Eine derartige, aus der GB-A-1 473 633 bekannte Vorrichtung weist eine Reihe von Signallampen auf, die in Abhängigkeit vom Ladezustand der zu überwachenden Batterie nacheinander aufleuchten. Eine solche Vorrichtung lässt den jeweiligen Ladezustand durch die Anzahl der aufleuchtenden Signallampen erkennen. Da sich der Benutzer in der Regel daran gewöhnt, dass mehr oder weniger Signallampen aufleuchten, wird dessen Aufmerksamkeit in bezug auf die Überwachung mit der Zeit nachlassen. Es fällt dann nicht mehr besonders auf, wenn der Ladezustand der Batterie einen kritischen Wert unterschreitet. Ferner ist die bekannte Vorrichtung verhältnismässig aufwendig, insbesondere durch die Anordnung zum stufenweisen Schalten der Signallampen in Abhängigkeit von Analogwerten einer vom Batteriestrom abgeleiteten Eingangsspannung.

Aus der EP-A-0 207 054 ist ferner ein Gerät, insbesondere Lampe, mit einer vorzugsweise aufladbaren Batterie bekannt. Dieses Gerät weist neben einer Ladeeinrichtung und einem Fadenbruch-Detektor für die Lampe auch einen mittels eines Operationsverstärkers aufgebauten Komparator auf, von dem ein Eingang über einen Spannungsteiler an die zu überwachende Batterie angeschlossen ist. An den Referenzeingang dieses Komparators wird unter anderem über einen Spannungsteiler ein von der Batterie abgeleitetes Potential angelegt. Der Komparatorausgang ist mit einer Anzeigeeinrichtung zur Anzeige der bestimmten MindestEnergiereserve verbunden. Der an den genannten Referenzeingang angeschlossene Spannungsteiler legt die Grenze für die tiefste Entladung der Batterie fest und erzeugt - durch Sperren der Schalter für die Lampen - die genannte Anzeige.

Aus der US-Patentschrift 4 558 281 ist ferner eine kombinierte Vorrichtung bekannt, welche zum Errechnen des Ladezustandes einer Blei-Säure-Traktionsbatterie und zum Steuern eines Fahrzeugantriebes dient. Der Minuspol der Batterie ist mit einem Messwiderstand zur Erfassung des Stromes in Reihe geschaltet. Ein Spannungsdetektor dient zur Erfassung der Batteriespannung und ein Temperaturfühler zum Erfassen der Batterietemperatur. Die gemessenen Werte der Batteriespannung, des Stromes und der Batterietemperatur werden auf einen Mikrocomputer übertragen, der durch Integration des Stromes die gezogene Ladung und aufgrund der Batteriespannung die verbleibende Ladung und dann den Ladezustand der Batterie errechnet und zur Anzeige bringt. Ferner bewirkt die Vorrichtung eine Reduktion der abgegebenen Leistung, wenn sich die Energiereserve dem Ende nähert.

Der Erfindung liegt die Aufgabe zugrunde, eine Vorrichtung der eingangs genannten Art zu schaffen, durch die mit relativ geringem Aufwand eine bestimmte Mindest-Energiereserve einer Batterie erkannt und gesichert wird, um die Start- und Betriebsfähigkeit der damit betriebenen Einrichtung zu gewährleisten.

Die gestellte Aufgabe wird erfindungsgemäss durch die im Anspruch 1 angegebenen Merkmale gelöst.

In den abhängigen Ansprüchen werden bevorzugte Ausführungsformen der Erfindung beansprucht.

Die erfindungsgemässe Vorrichtung warnt den Benutzer durch ein abgegebenes Signal vor einem bevorstehenden Ausfall der Batterie. Dadurch wird die Mindest-Energiereserve rechtzeitig erkannt, so dass diese Reserve noch ausreicht, die Startfähigkeit und die Betriebsfähigkeit, beispielsweise eines Fahrzeuges, zu gewährleisten. Im Unterschied zu einer Ladezustandsanzeige dient die erfindungsgemässe Vorrichtung als Warneinrichtung. Ihr Ausgangssignal kann durch einen optischen oder akustischen Signalgeber abgegeben oder an eine Zentralelektronik weitergeleitet werden.

Als Reaktion müssen dann entweder durch den Fahrer oder automatisch vorübergehend nicht benötigte Verbraucher abgeschaltet werden, so dass der der Batterie zum Laden zugeführte Strom grösser ist als der momentan entnommene Strom. Sobald die Mindest-Energiereserve nicht mehr unterschritten ist, erlischt die Anzeige im Fall einer Signallampe.

Die Ansprechschwelle ist vorzugsweise in einem Bereich zwischen 15% und 35% durch entsprechende Bemessung der Schaltungsanordnung festzulegen. Für die Bestimmung der Energiereserve werden erfindungsgemäss die Spannung, der Strom und die Temperatur der Batterie erfasst und ausgewertet.

Gemäss einer bevorzugten Ausführungsform der Erfindung bilden der Messwiderstand und der elektronische Schaltkreis eine unmittelbar am Minuspol der Batterie anbaubare konstruktive Einheit. Der Messwiderstand wird zwischen den Minuspol der Batterie und einem Masseanschluss des Fahrzeuges geschaltet. Der Anschluss am Pluspol der Batterie und die Anzeigevorrichtung sind extern zu verdrahten.

Anhand der Zeichnungen wird ein Ausführungsbeispiel der Erfindung näher erläutert. Es zeigen:

Fig. 1    Ein Schaltbild einer Vorrichtung zur Überwachung und Anzeige einer Mindest-Energiereserve einer Batterie, mit Generator und Verbraucher, und

Fig. 2    eine konstruktive Ausführung der Vorrichtung, angeordnet am Minuspol der Batterie.

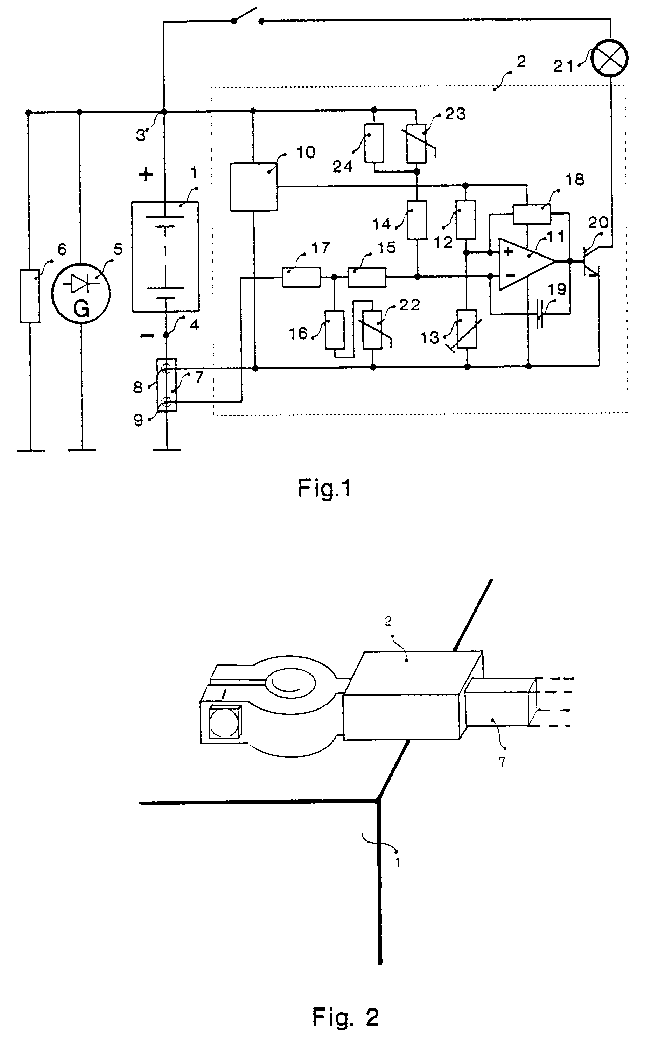

In der Fig. 1 ist eine zu überwachende Batterie **1**, insbesondere eine Fahrzeug-Bleibatterie, mit ihrem Minuspol **4** über einen Messwiderstand **7** mit einem Masseanschluss eines nicht dargestellten Fahrzeuges verbunden. Der Pluspol **3** der Batterie **1** ist mit einem Generator **5**, mit mindestens einem Verbraucher **6** und mit einem elektronischen Schaltkreis **2** verbunden. Generator **5** und Verbraucher **6** sind ferner mit Masseanschlüssen des Fahrzeuges verbunden. Die batterieseitige erste Anschlussklemme **8** des Messwiderstandes **7** ist mit dem Massepotential des elektronischen Schaltkreises **2** verbunden. An der der Batterie **1** abgewandten, mit einem Masseanschluss des Fahrzeuges verbundenen, zweiten Anschlussklemme **9** des Messwiderstandes **7** wird ein vom Strom der Batterie 1 abhängiges Stromsignal für den elektronischen Schaltkreis **2** gewonnen.

Der elektronische Schaltkreis **2** weist einen Spannungsregler **10**, einen Operationsverstärker **11**, einen Kondensator **19**, einen Schalttransistor **20**, mehrere Widerstände und zwei Heissleiter **22**, **23** auf.

Der Operationsverstärker **11** weist einen invertierenden Eingang - und einen nicht invertierenden Eingang **+** auf. Der invertierende Eingang **-** ist an einen ersten Spannungsteiler **23**, **24**, **14**, **15**, **16**, **17**, **22** angeschlossen. Der nicht invertierende Eingang **+** ist an einen zweiten Spannungsteiler **12**, **13** angeschlossen.

Der mit dem Pluspol **3** der Batterie **1** und der ersten Anschlussklemme 8 des Messwiderstandes **7** verbundene Spannungsregler **10** versorgt den Operationsverstärker **11** und liefert an dessen nicht invertierenden Eingang **+** eine einstellbare Referenzspannung über den zweiten Spannungsteiler **12**, **13**. Dieser weist zwei Widerstände auf, von denen der erste **12** mit dem Ausgang des Spannungsreglers **10** und der zweite **13** als Abgleichwiderstand mit dem Massepotential verbunden ist. Die Referenzspannung ist am Abgleichwiderstand **13** einstellbar.

Der erste Spannungsteiler weist am invertierenden Eingang - in seinem ersten Zweig einen ersten Eingangswiderstand **15** und in seinem zweiten Zweig einen zweiten Eingangswiderstand **14** auf. Das Verhältnis des zweiten Eingangswiderstandes **14** zum ersten Eingangswiderstand **15** beträgt 100 : 1.

Der erste Zweig des ersten Spannungsteilers ist über einen weiteren Widerstand **17** mit der zweiten Anschlussklemme **9** des Messwiderstandes **7** verbunden. Zwischen dem ersten Eingangswiderstand **15** und dem weiteren Widerstand **17** ist eine Reihenschaltung aus einem Vorwiderstand **16** und dem ersten Heissleiter **22** zum Massepotential abgezweigt.

Der zweite Zweig des ersten Spannungsteilers ist über den zweiten Heissleiter **23** mit dem Pluspol **3** der Batterie **1** verbunden. Der zweite Heissleiter **23** ist mit einem Parallelwiderstand **24** geshunted.

Die aus den Widerständen **16**, **17** und dem ersten Heissleiter **22** bestehende Reihenschaltung liegt parallel zum Messwiderstand **7** und dient als Spannungsteiler zur Anpassung der vom Messwiderstand **7** abgeleiteten Messwerte und zur Bestimmung des Einflusses der Temperatur der Batterie **1**. Der weitere Widerstand **17** ist etwa zwei Grössenordnungen kleiner als der erste Eingangswiderstand **15**.

Die zur Erfassung der Temperatur der Batterie **1** bestimmten Heissleiter **22**, **23** erfordern einen einwandfreien thermischen Kontakt mit der Batterie.

Die gewünschte Funktion wird in zwei Schritten erreicht:

Erstens wird die zu überwachende Batterie nach herkömmlichen Methoden auf die zu bestimmende Mindest-Energiereserve, beispielsweise auf 25%, gebracht. Dabei beträgt die Leerlaufspannung einer 12 Volt-Batterie etwa 11,65 V. Mit dem Abgleichwiderstand **13** wird die Schaltschwelle derart eingestellt, dass der Operationsverstärker **11** an seinem Ausgang von 0 auf I schaltet. Mit einem zwischen dem nicht invertierenden Eingang **+** des Operationsverstärkers **11** und seinem Ausgang liegenden Widerstand **18** wird die Hysterese derart eingestellt, dass der Operationsverstärker **11** an seinem Ausgang bei einer Leerlaufspannung der Batterie **1** von 12,65 V auf 0 zurückschaltet.

Zweitens wird der Einfluss des Entladestromes auf die Spannung der Batterie **1** ermittelt und für den elektronischen Schaltkreis **2** definiert. Dazu wird der typische Spannungsabfall $\Delta U_B$ des jeweiligen Batterietyps bei 25% Energiereserve als Differenz der Leerlaufspannung und der Klemmenspannung bei Belastung errechnet.

Um den Spannungsabfall $\Delta U_B$ am invertierenden Eingang - des Operationsverstärkers **11** zu kompensieren, muss die am Messwiderstand **7** abfallende Spannung am ersten Eingangswiderstand **15** 1/100 des Spannungsabfalls $\Delta U_B$ betragen.

Der zwischen den invertierenden Eingang - des Operationsverstärkers **11** und seinen Ausgang geschaltete Kondensator **19** dient zur Unterdrückung von Störimpulsen.

Der durch den Ausgang des Operationsverstärkers **11** gesteuerte Schalttransistor **20** schaltet durch sein Ausgangssignal eine Lampe **21** oder eine Leuchtdiode.

Es ist möglich, die Energiereserve-Werte zwischen 0 und 100% festzulegen, dazu mehrere elektronische Schaltkreise der beschriebenen Art entsprechend zu bemessen und am selben Messwiderstand **7** anzuschliessen. So lassen sich beispielsweise Werte von 25%, 50%, 75% und 100% festlegen und anzeigen.

Die Fig. 2 zeigt eine angedeutete Batterie **1**, an deren Minuspol der Messwiderstand **7** mit dem elektronischen Schaltkreis **2** befestigt ist.

**Patentansprüche**

1. Vorrichtung zur Überwachung und Anzeige einer bestimmten Mindest-Energiereserve einer Batterie **(1)**, insbesondere Blei-Säure-Batterie, in einem Fahrzeug, mit einem zum Anschluss und die zu überwachenden Batterie **(1)** bestimmten Messwiderstand **(7)**, von dem eine Anschlussklemme **(8)** das Massepotential eines elektronischen Schaltkreises **(2)** bestimmt, der einen Operationsverstärker **(11)** aufweist, an dessen nicht invertierenden Eingang **(+)** eine Referenzspannung angelegt ist, dadurch gekennzeichnet, dass der Messwiderstand **(7)** zur Verbindung mit dem Minuspol **(4)** der Batterie **(1)** bestimmt ist, dass die batterieseitige, erste Anschlussklemme **(8)** des Messwiderstandes **(7)** mit dem Massepotential des elektronischen Schaltkreises **(2)** verbunden ist, dass der invertierende Eingang **(-)** des Operationsverstärkers **(11)** an einen aus Widerständen **(23, 24, 14, 15, 16, 17, 22)** gebildeten ersten Spannungsteiler angeschlossen ist, dessen eines Ende zum Verbinden mit dem Pluspol **(3)** der Batterie **(1)** bestimmt ist und dessen anderes Ende mit der von der Batterie **(1)** abgewandten zweiten Anschlussklemme **(9)** des Messwiderstandes **(7)** verbunden ist, dass die Referenzspannung über einen zweiten Spannungsteiler **(12, 13)** vom Ausgang eines der Batterie **(1)** parallelgeschalteten Spannungsreglers **(10)** abgeleitet ist, dass der Operationsverstärker **(11)** ein eine Mindest-Energiereserve anzeigendes Ausgangssignal liefert, wenn die Spannung am invertierenden Eingang **(-)** die Referenzspannung unterschreitet und dass dieses Ausgangssignal bis zur erneuten Ladung der Batterie **(1)** bestehen bleibt.

2. Vorrichtung nach Anspruch 1, dadurch gekennzeichnet, dass der erste Spannungsteiler in seinem zwischen dem invertierenden Eingang **(-)** des Operationsverstärkers **(11)** und der zweiten Anschlussklemme **(9)** des Messwiderstandes **(7)** liegenden ersten Zweig **(15, 17)** einen ersten Eingangswiderstand **(15)** und in seinem zwischen dem invertierenden Eingang **(-)** des Operationsverstärkers **(11)** und dem Pluspol **(3)** der Batterie **(1)** liegenden zweiten Zweig **(14, 23, 24)** einen zweiten Eingangswiderstand **(14)** aufweist, dass das Verhältnis des Spannungsabfalls ($\Delta U_B$) an der Batterie **(1)** bei Belastung zu der am ersten Eingangswiderstand **(15)** gemessenen Spannung gleich gross ist, wie das Verhältnis des zweiten Eingangswiderstandes **(14)** zum ersten Eingangswiderstand **(15)**, welches beispielsweise 100 zu 1 gewählt wird, dass der erste Spannungsteiler eine parallel zum Messwiderstand **(7)** liegende Reihenschaltung aus einem Heissleiter **(22)** und Widerständen **(16, 17)** aufweist, um mittels dieser einen Spannungsteiler bildenden Reihenschaltung die Spannung des Messwiderstandes **(7)** anzupassen, und dass der Messwiderstand **(7)** derart bemessen ist, dass an ihm eine Spannung abfällt, die grösser ist als ein Hundertstel des Spannungsabfalls ($\Delta U_B$) der Batterie **(1)**.

3. Vorrichtung nach Anspruch 2, dadurch gekennzeichnet, dass der Spannungsabfall ($\Delta U_B$) der Batterie **(1)** nach Einstellung der zu messenden, bestimmten Mindest-Energiereserve nach der folgenden Formel errechnet wird

$$\Delta U_B = U_{BL} - U_{BB}$$

wobei $U_{BL}$ die bei der bestimmten Mindest-Energiereserve gemessene Leerlaufspannung der Batterie **(1)** und $U_{BB}$ die bei der bestimmten Mindest-Energiereserve mit einer definierten Belastung gemessene Klemmenspannung der Batterie **(1)** darstellt.

4. Vorrichtung nach Anspruch 3, dadurch gekennzeichnet, dass die Referenzspannung am nicht invertierenden Eingang **(+)** des Operationsverstärkers **(11)** auf die Leerlaufspannung $U_{BL}$ der Batterie **(1)** der bestimmten Mindest-Energiereserve abgestimmt ist.

5. Vorrichtung nach Anspruch 2, dadurch gekennzeichnet, dass der erste Spannungsteiler zwei zur thermischen Ankopplung an die Batterie **(1)** bestimmte Heissleiter **(22, 23)** aufweist, von denen der erste **(22)** in der parallel zum Messwiderstand **(7)** liegenden Reihenschaltung enthalten ist und den Temperatureinfluss derart festlegt, dass das Verhältnis des Spannungsabfalls ($\Delta U_B$) der Batterie **(1)** zu der am ersten Eingangswiderstand **(15)** anliegenden Spannung im gesamten Arbeitstemperaturbereich annähernd konstant bleibt, und dass der zweite Heissleiter **(23)** in Serie mit dem zweiten Eingangswiderstand **(14)** des Operationsverstärkers **(11)** und parallel zu einem weiteren Widerstand **(24)** zwischen dem Pluspol (3) der Batterie **(1)** und dem invertierenden Eingangs **(-)** des Operationsverstärkers **(11)** angeordnet ist und zur Anpassung der Leerlaufspannung der Batterie **(1)** im Arbeitstemperaturbereich dient.

6. Vorrichtung nach Anspruch 1, dadurch gekennzeichnet, dass der Ausgang des Operationsverstärkers **(11)** über einen Widerstand **(18)** mit seinem nicht invertierenden Eingang **(+)** und über einen Kondensator **(19)** mit seinem invertierenden Eingang **(-)** verbunden ist.

7. Vorrichtung nach einem der Ansprüche 2 bis 6, dadurch gekennzeichnet, dass am Messwiderstand **(7)** mehrere elektronische Schaltkreise **(2)** anschliessbar sind, die auf die jeweiligen Leerlaufspannungen der zu überwachenden Batterie **(1)** und den zugehörigen Spannungsabfall eingestellt sind, von denen jeder Schaltkreis zur Anzeige einer weiteren beliebigen Energiereserve der Batterie **(1)** dient, beispielsweise 50%, 75% und 100%.

8. Vorrichtung nach einem der vorstehenden Ansprüche, dadurch gekennzeichnet, dass der Messwiderstand **(7)** und die Elemente des elektronischen Schaltkreises **(2)** eine zum Anbau an den Minuspol **(4)** der Batterie **(1)** bestimmte konstruktive Einheit bilden.

9. Vorrichtung nach einem der Ansprüche 1 bis 7, dadurch gekennzeichnet, dass der Messwiderstand **(7)** und die Elemente des elektronischen Schaltkreises **(2)** als getrennte Einheiten ausgebildet sind und dass die als Temperaturfühler dienenden Heissleiter (22, 23) zum Anbringen mit einem einwandfreien thermischen Kontakt an der Batterie **(1)** bestimmt und mit dem elektronischen Schaltkreis **(2)** über Drähte verbunden sind.

## Claims

1. A device for the monitoring and display of a specific minimum energy reserve of a battery (1), in particular a lead/acid battery, in a vehicle, with a measurement resistance (7) intended for connection to the battery (1) which is to be monitored, of which a connecting terminal (8) determines the mass potential of an electronic switching circuit (2), which has an operational amplifier (11), at the non-inverting input (+) of which a reference voltage is applied, characterised in that the measurement resistance (7) is intended for connection with the negative pole (4) of the battery (1), that the first connecting terminal (8) of the measurement resistance (7), on the battery side, is connected with the mass potential of the electronic switching circuit (2), that the inverting input (-) of the operational amplifier (11) is connected to a first voltage divider formed from resistances (23, 24, 14, 15, 16, 17, 22), one end of which is intended for connecting with the positive pole (3) of the battery (1) and the other end of which is connected with the second connecting terminal (9) of the measurement resistance (7), facing away from the battery (1), that the reference voltage is derived via a second voltage divider (12, 13) from the output of a voltage regulator (10) connected in parallel with the battery (1), that the operational amplifier (11) delivers an output signal indicating a minimum energy reserve, when the voltage at the inverting input (-) falls below the reference voltage and that this output signal remains in existence until the renewed charging of the battery (1).

2. A device according to Claim 1, characterised in that the first voltage divider has in its first branch (15, 17) lying between the inverting input (-) of the operational amplifier (11) and the second connecting terminal (9) of the measurement resistance (7) a first input resistance (15) and in its second branch (14, 23, 24) lying between the inverting input (-) of the operational amplifier (11) and the positive pole (3) of the battery (1) a second input resistance (14), that the ratio of the voltage drop ($\Delta U_B$) at the battery (1) on loading to the voltage measured at the first input resistance (15) is equally as great as the ratio of the second input resistance (14) to the first input resistance (15), which is selected for example to be 100 to 1, that the first voltage divider has a series arrangement of a thermistor (22) and resistances (16, 17) lying parallel to the measurement resistance (7), in order to adapt the voltage of the measurement resistance (7) by means of this series arrangement, forming a voltage divider, and that the measurement resistance (7) is dimensioned such that a voltage drops at it which is greater than one hundredth of the voltage drop ($\Delta U_B$) of the battery (1).

3. A device according to Claim 2, characterised in that the voltage drop ($\Delta U_B$) of the battery (1) after setting of the specific minimum energy reserve which is to be measured is calculated according to the following formula

$$\Delta U_B = U_{BL} - U_{BB}$$

in which $U_{BL}$ represents the no-load voltage of the battery (1) measured with the specific minimum energy reserve and $U_{BB}$ represents the terminal voltage of the battery (1) measured at the specific minimum energy reserve with a defined load.

4. A device according to Claim 3, characterised in that the reference voltage at the non-inverting input (+) of the operational amplifier (11) is coordinated with the no-load voltage $U_{BL}$ of the battery (1) of the specific minimum energy reserve.

5. A device according to Claim 2, characterised in that the first voltage divider has two thermistors (22, 23) intended for thermal coupling to the battery (1), the first (22) of which is contained in the series arrangement lying parallel to the measurement resistance (7) and establishes the temperature influence such that the ratio of the voltage drop ($\Delta U_B$) of the battery (1) to the voltage applied to the first input resistance (15) remains approximately constant in the entire operating temperature range, and that the second thermistor (23) is arranged in series with the second input resistance (14) of the operational amplifier (11) and parallel to a further resistance (24) between the positive pole (3) of the battery (1) and the inverting input (-) of the operational amplifier (11) and serves to adapt the no-load voltage of the battery (1) in the operating temperature range.

6. A device according to Claim 1, characterised in that the output of the operational amplifier (11) is connected via a resistance (18) with its non-inverting input (+) and is connected via a capacitor (19) with its inverting input (-).

7. A device according to one of Claims 2 to 6, characterised in that at the measurement resistance (7) several electronic switching circuits (2) are able to be connected, which are adjusted to the respective no-load voltages of the battery (1) which is to be monitored and to the associated voltage drop, of which each switching circuit serves to indicate a further arbitrary energy reserve of the battery (1), for example 50%, 75% and 100%.

8. A device according to one of the above claims, characterised in that the measurement resistance (7) and the elements of the electronic switching circuit (2) form a structural unit intended for attachment to the negative pole (4) of the battery (1).

9. A device according to one of Claims 1 to 7, characterised in that the measurement resistance (7) and the elements of the electronic switching circuit (2) are constructed as separate units and that the thermistors (22, 23), serving as temperature sensors, are intended for arrangement with an efficient thermal contact on the battery (1) and are connected with the electronic switching circuit (2) via wires.

**Revendications**

1. Dispositif de contrôle et d'indication d'une réserve d'énergie minimale d'une batterie (1), en particulier d'une batterie au plomb-acide, dans un véhicule, comprenant une résistance série (7) destinée au branchement sur la batterie (1) à contrôler et dont une borne (8) détermine le potentiel de masse d'un circuit électronique (2) comportant un amplificateur opérationnel (11), à l'entrée (+) non inverseuse duquel est appliquée une tension de référence, **caractérisé en** ce que la résistance série (7) est destinée au branchement sur le pôle négatif (4) de la batterie (1), que la première borne (8) de la résistance série (7) située du côté batterie est reliée au potentiel de masse du circuit électronique (2), que l'entrée (-) inverseuse de l'amplificateur opérationnel (11) est reliée à un premier diviseur de tension formé par des résistances (23, 24, 14, 15, 16, 17, 22), dont l'une des extrémités est prévue pour le branchement sur le pôle positif (3) de la batterie (1) et dont l'autre extrémité est reliée à la seconde borne (9) de la résistance série (7) opposée à la batterie (1), que la tension de référence est dérivée, par l'intermédiaire d'un second diviseur de tension (12, 13), de la sortie d'un régulateur de tension (10) monté en parallèle avec la batterie (1), que l'amplificateur opérationnel (11) fournit un signal de sortie indiquant la réserve d'énergie minimale lorsque la tension appliquée à l'entrée (-) inverseuse descend en dessous de la tension de référence, et que ce signal de sortie est conservé jusqu'à une nouvelle charge de la batterie (1).

2. Dispositif selon la revendication 1, caractérisé en ce que le premier diviseur de tension comprend dans sa première branche (15, 17) située entre l'entrée (-) inverseuse de l'amplificateur opérationnel (11) et la seconde borne (9) de la résistance série (7), une première résistance d'entrée (15) et, dans sa seconde branche (14, 23, 24) située entre l'entrée (-) inverseuse de l'amplificateur opérationnel (11) et le pôle positif (3) de la batterie (1), une seconde résistance d'entrée (14), que le rapport entre la chute de tension ($\Delta U_B$) sur la batterie (1) sous charge et la tension mesurée sur la première résistance d'entrée (15) est égal au rapport entre la seconde résistance d'entrée (14) et la première résistance d'entrée (15) lequel est choisi par exemple comme étant de 100 : 1, que le premier diviseur de tension comporte, en parallèle avec la résistance série (7), un montage en série constitué par une thermistance (22) et des résistances (16, 17) pour adapter la tension de la résistance série (7) au moyen de ce montage en série formant un diviseur de tension, et que la résistance série (7) est dimensionnée de telle façon qu'elle provoque une chute de tension qui est supérieure à un centième de la chute de tension ($\Delta U_B$) de la batterie (1).

3. Dispositif selon la revendication 2, caractérisé en ce que la chute de tension ($\Delta U_B$) de la batterie (1) est calculée d'après la formule suivante, après le réglage de la réserve d'énergie minimale déterminée à mesurer

$$\Delta U_B = U_{BL} - U_{BB}$$

où $U_{BL}$ est la tension à vide de la batterie (1) mesurée à la réserve d'énergie minimale déterminée, et $U_{BB}$, la tension aux bornes de la batterie (1) mesurée pour une réserve d'énergie minimale déterminée avec une charge définie.

4. Dispositif selon la revendication 3, caractérisé en ce que la tension de référence à l'entrée (+) non inverseuse de l'amplificateur opérationnel (11) est adaptée à la tension à vide $U_{BL}$ de la batterie (1) pour la réserve d'énergie minimale déterminée.

5. Dispositif selon la revendication 2, caractérisé en ce que le premier diviseur de tension comprend deux thermistances (22, 23) destinées au couplage avec la batterie (1) et dont le premier (22) fait partie du montage en série monté en parallèle avec la résistance série (7) et fixe l'influence de la température de telle façon que le rapport entre la chute de tension ($\Delta U_B$) de la batterie (1) et la tension appliquée à la première résistance d'entrée (15) reste sensiblement constant dans la totalité de la plage des températures de travail, et que la seconde thermistance (23) montée en série avec la seconde résistance d'entrée (14) de l'amplificateur opérationnel (11) et en parallèle avec une résistance supplémentaire (24), est disposée entre le pôle positif (3) de la batterie (1) et l'entrée (-) inverseuse de l'amplificateur opérationnel (11) et destiné à l'adaptation de la tension à vide de la batterie (1) dans la plage des températures de travail.

6. Dispositif selon la revendication 1, caractérisé en ce que la sortie de l'amplificateur opérationnel (11) est reliée, par l'intermédiaire d'une résistance (18), à son entrée (+) non inverseuse et, par l'intermédiaire d'un condensateur (19), à son entrée (-) inverseuse.

7. Dispositif selon l'une des revendications 2 à 6, caractérisé en ce qu'à la résistance série (7) peuvent être connectés plusieurs circuits électroniques (2) qui sont réglés sur les tensions à vide respectives de la batterie (1) à contrôler et sur la chute de tension associée, chaque circuit servant à afficher à volonté une autre réserve d'énergie de la batterie (1), par exemple 50 %, 75 % et 100 %.

8. Dispositif selon l'une des revendications précédentes, caractérisé en ce que la résistance série (7) et les composants du circuit électronique (2) forment une unité de construction destinée à être montée sur le pôle négatif (4) de la batterie (1).

9. Dispositif selon l'une des revendications 1 à 7, caractérisé en ce que la résistance série (7) et les composants du circuit électronique (2) sont réalisés sous la forme d'unités séparées, et que les thermistances (22, 23) servant de sonde de température sont prévues pour être montées sur la batterie (1) avec un contact thermique parfait et qu'elles sont reliées au circuit électronique (2) par l'intermédiaire de fils.

Fig.1

Fig. 2